# EUROPEAN PATENT APPLICATION

(11) **EP 3 565 109 A1**
(43) Date of publication of application: **06.11.2019**
(21) Application number: 18197758.8
(22) Date of filing: 28.09.2018
(51) Int. Cl.: H02S 20/25

(54) **LAP MOUNTED SOLAR POWER GENERATION TILE**

(30) Priority: 13.04.2018 CN 201820526823 U; 11.06.2018 CN 201820896868 U
(71) Applicant: Guangdong Hanergy Thin-Film Solar Co., Ltd., Heyuan, Guangdong 517000 (CN)
(72) Inventor: ZHU, Yanjun, GUANGDONG, 517000 (CN); SUN, Shulong, GUANGDONG, 517000 (CN); TIAN, Jinhu, GUANGDONG, 517000 (CN)
(74) Representative: Cabinet Beau de Loménie

(57) **Abstract**

A lap mounted solar power tile, wherein a light receiving surface of the solar power generation tile is divided into a power generation area (1), a packaging area (2) and an installation occlusion area (3). The power generation area (1) is located inside the packaging area (2). The backlight surface of the solar power generation tile is provided with hooks (4) for mounting. The left and right sides of the solar power generation tile may be connected to adjacent solar power generation tiles in a lapping or snapping way.

## Description

### TECHNICAL FIELD

The present disclosure relates to a solar power generation tile technique field, and in particular, to a lap mounted solar power generation tile.

### BACKGROUND

Due to the problems of high pollution and depletion of reserves of traditional energy sources, people are paying more and more attention to the development of new energy, and have made certain achievements in the development of new energy. Solar technology has been widely used in the civilian areas, including BIPV building integration, rooftop power stations, agricultural greenhouses, and etc. Solar power generation tile is an emerging product that has recently been proposed to generate electricity and serves as building materials at the same time. At present, the solar power generation tile available from the market is mainly made of flexible thin film cells, has a curved tile structure, and its package structure is double glass or single glass structure. The single glass curved tile has great market potential and is widely used in roof building materials due to its light weight, high mechanical strength, good hydrophobicity and the like, which is similar with the traditional roof tile.

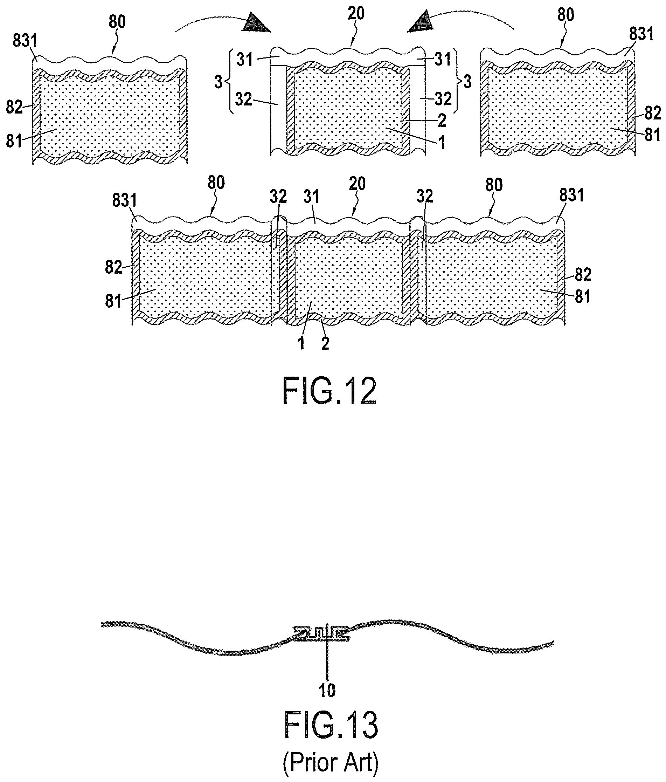

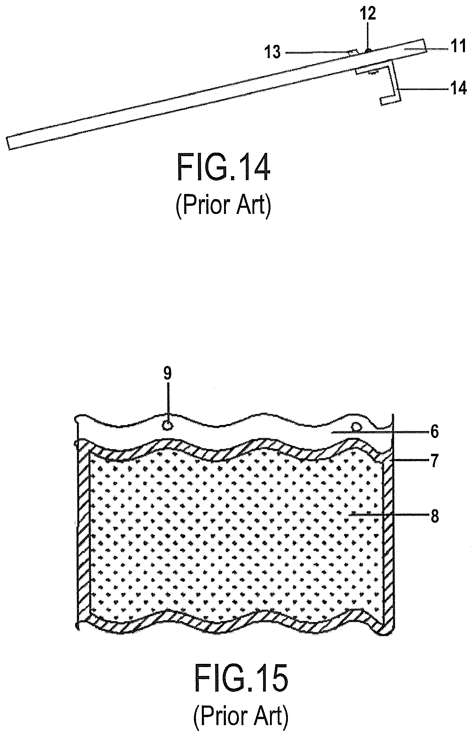

The curved tile in the related art shown in FIGS. 13-15 has several problems in the installation use process. Firstly, as shown in FIG.14 and FIG.15, the installation of the curved tile 11 requires the curved tile to be mounted on the roof purlins by a hook 14, and the hook 14 is fixed to the glass mounting hole 9 at a fixed position by a screw 12 and a gasket (not shown). Since the position of the glass mounting hole 9 can only be set in the mounting area 6, the hook can't be placed at the position carrying the maximum load in the area of the whole tile. At the same time, after drilling and installation, a part of the screw 2 will passes through the mounting hole and protrudes on the light receiving surface, which affects the lapping fit between the upper and lower tiles. In addition, opening the mounting hole in the glass to some extent causes the available area to decrease. Secondly, the current packaging structure of the single glass curved tile is a full-area package, except that the power generation area 8 is packaged, the mounting area 6 that doesn't generate electricity is often packaged with materials, resulting in waste of packaging materials. Thirdly, as shown in FIG. 13, the power generation tiles of such glass substrates are mainly lapped and installed by means of metallic parts 10 and a latching slot (not shown), the use of metallic parts 10 increases the cost of installation materials and consumes labor-hours, equipment and space, and also increases the production and uses costs, and the extra-installed metallic parts has a short service life that affects the service life of the overall power generation tile. Fourthly, the curved tile in the related art mainly prevents rainwater from being poured backward by the waterproof rubber strip 13 (as shown in FIG. 14) mounted on the light receiving surface, the tile is difficult to operate during installation, and the ability to prevent rainwater from being poured backward is poor in practical applications, and the waterproof rubber strip is difficult to make the upper and lower glass sheets fit tightly.

In summary, providing a solar power generation tile with low packaging cost, saving installation cost, flexible installation, strong ability to prevent rainwater from being poured backward and long service life is an urgent technical problem to be solved.

### SUMMARY

According to one aspect of the present disclosure, a lap mounted solar power generation tile is provided, wherein a light receiving surface of the solar power generation tile is divided into a power generation area, a packaging area and an installation occlusion area, wherein the power generation area is located inside the packaging area, and the installation occlusion area is located outside the package area, and the installation occlusion area includes a top occlusion area which is located on the top of the packaging area.

In some embodiments, the installation occlusion area further includes a side occlusion area, and the top of the side occlusion area extends to the lower end of the top occlusion area.

In some embodiments, the left and right sides of the solar power generation tile is connected to an adjacent solar power generation tile in a lapping or snapping way.

In some embodiments, the solar power generation tile includes a side occlusion region disposed on a side of the outside of the packaging area.

In some embodiments, the solar power generation tile includes two side occlusion regions disposed on two sides of the outside of the packaging area.

In some embodiments, the solar power generation tile has a symmetrical structure and the shapes of the left and right sides of the solar power generation tile are the same; and wherein when the solar power generation tile and an adjacent solar power generation tile are mounted in a lapping way, the side occlusion area of the solar power generation tile is overlapped beneath the adjacent solar power tile.

In some embodiments, when the shapes of the left and right sides of the solar power generation tile are complementary, and wherein when the solar power generation tile and an adjacent solar power generation tile are mounted in a snapping way, the side occlusion area (32) is snapped underneath the adjacent solar power generation tile.

In some embodiments, when a solar power generation tile including only the top occlusion area and a solar power generation tile including the top occlusion area and the two side occlusion areas are alternately arranged with each other, the two side occlusion regions overlap at least partially beneath adjacent solar power generation tiles.

In some embodiments, upper and lower ends of the solar power generation tile are connected to an adjacent solar power generation tile in a lapping way.

In some embodiments, each of the top occlusion area and the side occlusion area have a width of at least 10 cm.

In some embodiments, the backlight surface of the solar power generation tile is provided with at least one hook.

In some embodiments, the at least one hook is fixedly disposed at a peak position of the backlight surface of the solar power generation tile by an adhesive material.

In some embodiments, the peak position is a maximum load bearing force point.

In some embodiments, the number of the hooks is two or four.

In some embodiments, the solar power generation tile is a curved solar power generation tile.

### BRIEF DESCRIPTION OF THE DRAWINGS

FIG. 1 is a schematic view of the lap mounted solar power generation tile of the present disclosure;
FIG. 2 is a side view of the lap mounted solar power generation tile of the present disclosure;
FIG. 3 is a rear view 1 of the lap mounted solar power generation tile of the present disclosure;
FIG. 4 is a rear view 2 of the lap mounted solar power generation tile of the present disclosure;
FIG. 5 is a schematic view of the left and right tiles connected in a lap mounting way according to the lap mounted solar power generation tiles of the present disclosure;
FIG. 6 is a schematic view of the left and right tiles connected in a snap mounting way according to the lap mounted solar power generation tiles of the present disclosure;
FIG. 7 is a schematic view of the lap mounted solar power generation tile in an embodiment of the present disclosure;
FIG. 8 is a schematic view of the installation mode of the lap mounted solar power generation tile in the embodiment of the present disclosure as shown in Fig.7;
FIG. 9 is a schematic view of the lap mounted solar power generation tile in an embodiment of the present disclosure;
FIG. 10 is a schematic view of the installation mode of the lap mounted solar power generation tile in the embodiment of the present disclosure as shown in Fig.9;
FIG. 11 is a schematic view of the lap mounted solar power generation tile in an embodiment of the present disclosure;
FIG. 12 is a schematic view of the installation mode of the lap mounted solar power generation tile in the embodiment of the present disclosure as shown in Fig.11;
FIG. 13 is a schematic view of the installation mode of the solar power generation tiles in the related art;
FIG. 14 is a schematic view of the installation mode of the solar power generation tiles with hooks in the related art;
FIG. 15 is a schematic view of the solar power generation tiles in the related art.

### DETAILED DESCRIPTION

The present disclosure will be described in conjunction with the exemplary embodiments and the accompanying drawings hereinafter so that those skilled in the art can easily understand the technical solutions of the present disclosure.

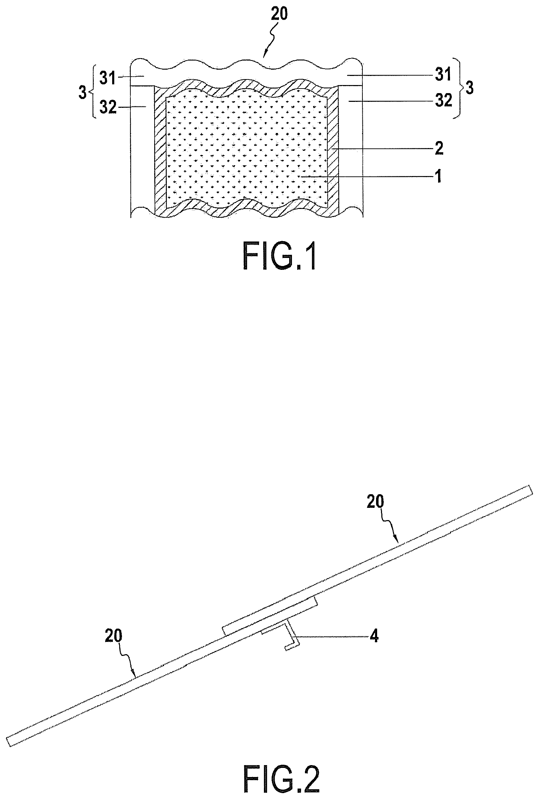

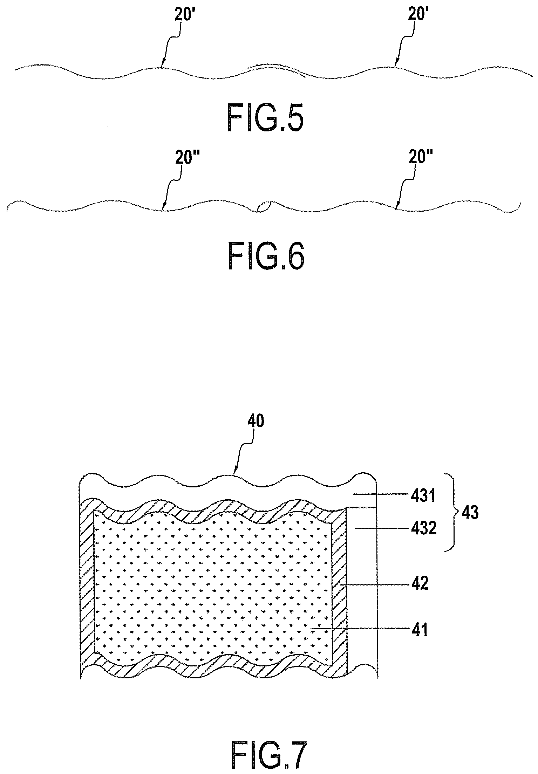

As shown in FIG. 1, FIG. 2 and FIG. 3, in a lap mounted solar power generation tile 20, the light receiving surface of the solar power generation tile is divided into a power generation area 1, a packaging area 2 and an installation occlusion area 3. The power generation area 1 is disposed inside the packaging area 2, and the installation occlusion area 3 is disposed along the outer edge of one or more sides of the packaging area 2. The installation occlusion area 3 includes a top occlusion area 31 and a side occlusion area 32. The top of the side occlusion area 32 extends to the lower end of the top occlusion area 31, and the top occlusion area 31 and the side occlusion area 32 are integrally formed during the process of packaging the power generation area 1 in the solar power generation tile. Thus, the top occlusion area 31 and the side occlusion area 32 form an installation occlusion area 3. When the number of the side occlusion areas 32 is one, the side occlusion area 32 is disposed on a side of the packaging area 2 away from the power generation area 1. When the number of the side occlusion areas 32 is two, the two side occlusion areas 32 are symmetrically disposed on both sides of the packaging area 2. The top occlusion area 31 and the side occlusion area 32 have a width of at least 10cm respectively. The backlight surface of the solar power generation tile is provided with a hook 4 for mounting and fixing, and the hook 4 is fixedly disposed at a peak position 5 of the backlight surface of the solar power generation tile by an adhesive material. The adhesive material is silica gel or strong adhesive tape. As shown in FIG. 2, the upper end of a solar power generation tile 20 may be lapped over a lower end of an adjacent solar power generation tile 20 in a lap mounting way. As shown in FIG.5, when the shape of the solar power generation tile 20' is a two-sided symmetrical structure, the left side of a solar power generation tile 20' may be lapped over the right side of an adjacent solar power generation tile 20' in a lapping mounting way. As shown in FIG.6, when the left and right ends of the solar power generation tile are complementary structures, for example, one edge is concave and the other edge is convex, then the left and right sides of the solar power generation tile 20" may be connected to adjacent solar power generation tiles 20" in a snapping way. The structure of the present disclosure can simplify the installation mode of the solar power generation tile, reduce the installation difficulty and save the installation cost. In one embodiment, the solar power generation tile in the present disclosure is a solar curved power generation tile. However, it should be noted that the way of lapping of the present disclosure is also applicable to a planar solar power generation tile, which will not be described in detail herein.

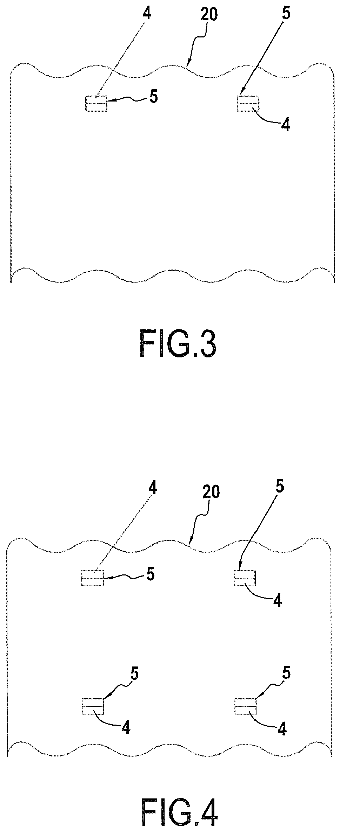

As shown in FIG. 3, when the number of the hooks 4 disposed on the backlight surface of the solar power generation tile 20 is two, the hooks may be symmetrically disposed on the peak position 5 of the upper half of the backlight surface. As shown in FIG. 4, when the number of the hooks 4 is four, the hooks may be evenly arranged on the peaks of the backlight surface, and two of them may be disposed on the upper half of the backlight surface, and the other two may be disposed on the lower half of the backlight surface. Or, optionally, the maximum load bearing force point can be calculated according to different roof inclination angles, and the hooks 4 may be installed on the maximum load bearing force point.

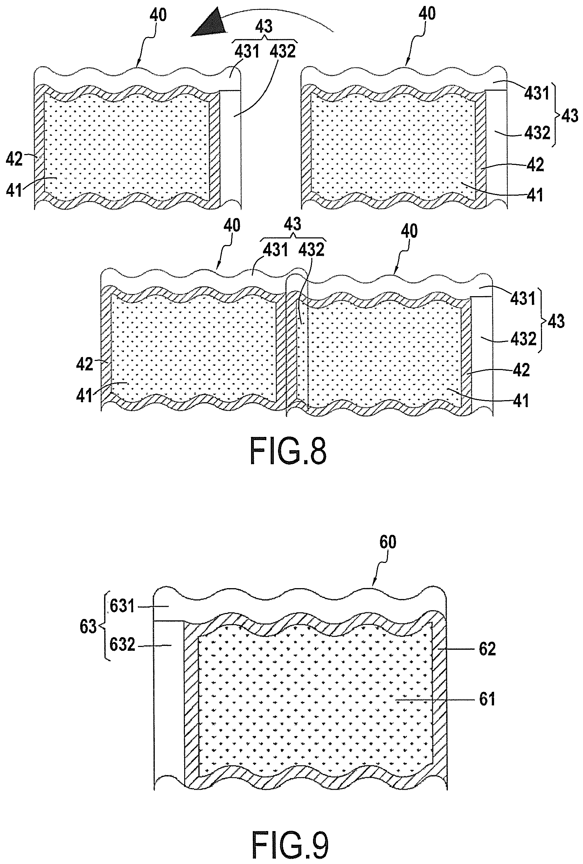

FIG. 7 illustrates a lap mounted solar power generation tile 40 in an embodiment of the present disclosure. The solar power generation tile 40 is a curve power generation tile, and the solar power generation tile is divided into a power generation area 41, a packaging area 42 and an installation occlusion area 43 including a top occlusion area 431 and a side occlusion area 432. As shown in FIG. 8, the solar power generation tile 40 is arranged to be connected by its right side lapped under the left side of the adjacent solar power generation tile 40, and spread in the right direction. That is to say, the solar power generation tile 40 on the left is the basis of the lap structure, and the left side of the adjacent solar power generation tile 40 on the right is disposed with its side occlusion area 432 lapped over the right side of the left solar power tile in a lap mounting way, and so on. In this way, the tiles 40 are spread in the right direction. The power generation area 41 is located inside the packaging area 42, the top of the packaging area 42 is provided with a top occlusion area 431 and the right side is provided with a side occlusion area 432, the top occlusion area 431 and the side occlusion area 432 form an installation occlusion area 43. The top occlusion area 431 and the right side occlusion area 432 have a width of 10 cm respectively. The backlight surface of the solar power generation tile is provided with a hook 4. The hook 4 is disposed at the position of a peak 5 of the backlight surface of the solar power generation tile. The hook 4 may be fixed by an adhesive material, such as a silica gel, and the number of the hooks 4 is four.

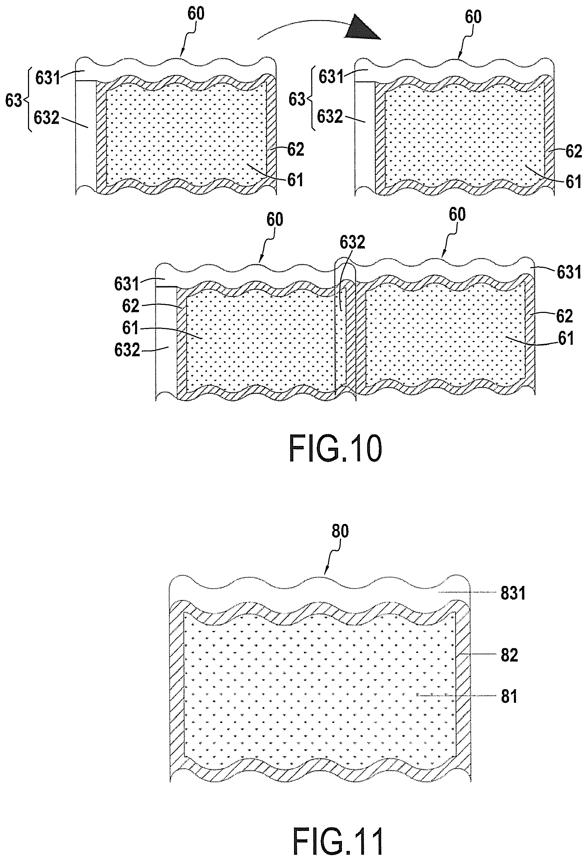

The FIG. 9 shows a lap mounted solar power generation tile 60 according to an embodiment of the present disclosure. The solar power generation tile 60 is a curve power generation tile, and the solar power generation tile is divided into a power generation area 61, a packaging area 62 and an installation occlusion area 63 including a top occlusion area 631 and a side occlusion area 632. FIG. 10 shows a left lap connection arrangement of the solar power generation tile 60 as shown in FIG. 9. When spreading to the left, the solar power generation tile 60 on the right is the basis of the lap structure, and the right side of the adjacent solar power generation tile 60 on the left side is lapped over the side occlusion area 632 on the left side of the solar power tile in a lapping way, and so on. The power generation area 61 is disposed inside the packaging area 62. The top of the packaging area 62 is provided with a top occlusion area 631 and the left side is provided with a side occlusion area 632, and the top occlusion area 631 and the side occlusion area 632 form an installation occlusion area 63. The top occlusion area 631 and the side occlusion area 632 have a width of 11 cm respectively. The backlight surface of the solar power generation tile is provided with a hook 4, and the hook 4 is disposed at the position of a peak 5 of the backlight surface of the solar power generation tile. The hook 4 is fixed by an adhesive material which is a strong adhesive tape, and the number of the hooks 4 is four.

As shown in FIGS. 1 and 11, a lap mounted solar power generation tile in the embodiment, the solar power generation tile 20 or 80 is a curve power generation tile. The solar power generation tile 20 or 80 is divided into a power generation area 1 or 81, a packaging area 2 or 82 and an installation occlusion area 3 or a top occlusion area 831. As shown in FIG. 12, the solar power generation tile 20 is arranged to be connected by a left and right lap connection, that is, the left and right sides of the middle solar power generation tile 20 are symmetrically provided with a side occlusion area 32, the right side of the solar power generation tile 80 on the left side is connected to the side occlusion area 32 on the left side of the middle solar power tile 20 in a lapping way, the left side of the solar power generation tile 80 on the right side is lapped over the side occlusion area 32 on the right side of the middle solar power generation tile 20 in a lapping way. The left and right solar power generation tiles 80 are all full-area package. The power generation area 1 of the middle solar power generation tile 20 is disposed inside the packaging area 2. The top of the packaging area 2 is provided with a top occlusion area 31 and the left and right sides are provided with a side occlusion area 32 respectively. The top occlusion area 31 and the side occlusion areas 32 on the left and right sides form an installation occlusion area 3. The top occlusion area 31 and the side occlusion area 32 have a width of 12 cm respectively. The power generation areas of the solar power generation tile 80 on the left side and the solar power generation tile 80 on the right side are both disposed inside the packaging area 82, which is full area packaging. The top of the packaging area 82 is provided with a top occlusion area 831 and has a width of 12 cm. The backlight surface of the solar power generation tile is provided with a hook 4, and the hook 4 is disposed at the position of a peak 5 of the backlight surface of the solar power generation tile. The hook 4 is fixed by an adhesive material which may be a silica gel. The number of the hooks 4 is two, and the hook 4 is installed on the upper half of the backlight surface.

The present disclosure provides a solar power generation tile with low packaging cost, low installation cost, flexible installation, strong ability to prevent rainwater from being poured backward and long service life.

Firstly, as to low packaging cost, the present disclosure provides a solar power generation tile with a novel packaging structure, the installation occlusion area is packaged without using a packaging material, and setting the packaging area according to the actual connection mode for packaging, ensuring effective use of the area of the packaging area, and reducing the package cost;

Secondly, as to saving installation costs, the solar power generation tiles provided by the present disclosure may be connected by overlapping lap or snap connection, when the shape of the solar power generation tile is a two-sided symmetrical structure, the overlapping lap is used to connect, when the left and the right ends of the shape of the solar power generation tile are complementary structures, for example, in the case of one curved edge is concave and the other curved edge is convex, the snapping is used to connect, and there is no need to connect by traditional installation of the latching slot, which reduces the consumption of installation materials, saves installation costs and achieves quick installation;

Thirdly, as to flexible installation, avoiding reduced available area, the solar power generation tiles of the present disclosure are fixedly connected to the roof purlin by hooks, and the hooks are connected to the backlight surface of the solar power generation tile, the connection positions of the hooks may be adjusted according to different sizes of the solar power generation tiles, the hooks can be installed in the backlight surface area of the entire power generation tile, and there is no need to open mounting holes on the curve glass to reduce the available area, and the lapping fit between the upper and the lower tiles will not be affected by the screw which passes through the mounting hole and protrudes on the light receiving surface;

Fourthly, as to strong ability to prevent rainwater repelling, the installation occlusion area provided by the disclosure has a large width, so that the overlapping area of the adjacent solar power generation tiles is large, which effectively prevents rainwater from being poured, and saves the use of waterproof rubber strips and improves the ability to prevent rainwater from being poured backward;

Fifth, as to long service life, the solar power generation tiles of the present disclosure is connected by lap or snap connection without using lap latching slot, which avoids the aging of the auxiliary parts and affecting overall service life.

The above description is only a preferred embodiment of the present disclosure, and is not intended to limit the disclosure in any way; the person skilled in the art can smoothly implement the present disclosure as shown in the drawings and described above. However, those skilled in the art can use the above-described technical content to make equivalent changes to a few changes, modifications, and evolutions without departing from the scope of the present disclosure, and are equivalent embodiments of the present disclosure; at the same time, any changes, modifications, and evolutions of any equivalent changes made to the above embodiments in accordance with the essential techniques of the present disclosure are still within the scope of the technical solutions of the present disclosure.

## Claims

1. A lap mounted solar power generation tile (20), wherein a light receiving surface of the solar power generation tile is divided into a power generation area (1), a packaging area (2) and an installation occlusion area (3), wherein the power generation area (1) is located inside the packaging area (2), and the installation occlusion area (3) is located outside the package area (2), and the installation occlusion area (3) includes a top occlusion area which is located on the top of the packaging area (2).

2. The solar power generation tile according to claim 1, wherein the installation occlusion area (3) further includes a side occlusion area (32), and the top of the side occlusion area (32) extends to the lower end of the top occlusion area (31).

3. The solar power generation tile according to claim 2, wherein the left and right sides of the solar power generation tile (20) is connected to an adjacent solar power generation tile (80) in a lapping or snapping way.

4. The solar power generation tile according to claim 3, wherein the solar power generation tile (20) includes a side occlusion region (32) disposed on a side of the outside of the packaging area (2).

5. The solar power generation tile according to claim 3, wherein the solar power generation tile includes two side occlusion regions (32) disposed on two sides of the outside of the packaging area (2).

6. The solar power generation tile according to claim 4, wherein the solar power generation tile (20) has a symmetrical structure and the shapes of the left and right sides of the solar power generation tile are the same; and wherein when the solar power generation tile (20) and an adjacent solar power generation tile (80) are mounted in a lapping way, the side occlusion area (32) of the solar power generation tile is overlapped beneath the adjacent solar power tile (80).

7. The solar power generation tile according to claim 4, wherein when the shapes of the left and right sides of the solar power generation tile (40) are complementary, and wherein when the solar power generation tile (40) and an adjacent solar power generation tile (40) are mounted in a snapping way, the side occlusion area (432) is snapped underneath the adjacent solar power generation tile.

8. The solar power generation tile according to claim 5, wherein when a solar power generation tile (80) including only the top occlusion area (831) and a solar power generation tile including the top occlusion area (31) and the two side occlusion areas (32) are alternately arranged with each other, the two side occlusion regions (32) overlap at least partially beneath adjacent solar power generation tiles (80).

9. The solar power generation tile according to claim 2, wherein upper and lower ends of the solar power generation tile are connected to an adjacent solar power generation tile in a lapping way.

10. The solar power generation tile according to any one of claims 1 to 9, wherein each of the top occlusion area (31) and the side occlusion area (32) have a width of at least 10 cm.

11. The solar power generation tile according to any one of claims 1 to 9, wherein the backlight surface of the solar power generation tile (20) is provide with at least one hook (4).

12. The solar power generation tile according to claim 11, wherein the at least one hook (4) is fixedly disposed at a peak (5) position of the backlight surface of the solar power generation tile (20) by an adhesive material.

13. The solar power generation tile according to claim 12, wherein the peak (5) position is a maximum load bearing force point.

14. The solar power generation tile according to claim 11, wherein the number of the hooks (4) is two or four.

15. The solar power generation tile according to any one of claims 1 to 14, wherein the solar power generation tile is a curved solar power generation tile.
